Europäisches Patentamt

European Patent Office

Office européen des brevets

(11) Veröffentlichungsnummer: **0 472 240 A2**

# (12) EUROPÄISCHE PATENTANMELDUNG

(21) Anmeldenummer: **91202087.2**

(22) Anmeldetag: **15.08.91**

(51) Int. Cl.5: **G11C 16/04**

(30) Priorität: **21.08.90 DE 4026409**

(43) Veröffentlichungstag der Anmeldung:
**26.02.92 Patentblatt 92/09**

(84) Benannte Vertragsstaaten:
**DE FR GB NL**

(71) Anmelder: **Philips Patentverwaltung GmbH**
**Wendenstrasse 35 Postfach 10 51 49**
**W-2000 Hamburg 1(DE)**
(84) **DE**

(71) Anmelder: **N.V. Philips' Gloeilampenfabrieken**

**Groenewoudseweg 1**
**NL-5621 BA Eindhoven(NL)**
(84) **FR GB NL**

(72) Erfinder: **Frerichs, Heinz-Peter, Dr.rer.nat.**
**Bismarckstrasse 60**
**W-2000 Hamburg 20(DE)**

(74) Vertreter: **Poddig, Dieter, Dipl.-Ing. et al**
**Philips Patentverwaltung GmbH**
**Wendenstrasse 35 Postfach 10 51 49**
**W-2000 Hamburg 1(DE)**

(54) **Elektrisch programmier- und löschbarer Halbleiterspeicher und Verfahren zu seinem Betrieb.**

(57) Halbleiterspeicher mit elektrisch mit Tunnelstrom programmier- und löschbaren, nichtflüchtigen Speicherzellen (EEPROM) mit einem Floating-Gate-Transistor, die in Speicherzellengruppen mit je n Zeilen und in m Spalten geordnet sind, wobei n Zellen in Serie geschaltet sind und diese serielle Verbindung die Bit-Leitung für die Spalten eines Zellenblocks bildet, daß das Controll-Gate m nebeneinanderliegenden Speicherzellen einer Zeile des Zellenblocks gemeinsam ist und die Wort-Leitung für die Zeile der Speicherzellengruppe bildet. Das Floating-Gate erstreckt sich nicht über die gesamte Weite des Kanals, so daß in jeder Speicherzelle ein dem Floating-Gate-Transistor parallel geschalteter, nur durch das Controllgate gesteuerter Parallel-Transistor gebildet ist, der beim Lesen bei jeder nicht selektierten Zelle leitend ist. Dadurch wird das Problem des Überlöschens (over erasing) auch bei kurzen Zugriffszeiten gelöst, ohne daß ein zusätzlicher Zugriffstransistor erforderlich ist.

FIG.3

Die Erfindung betrifft einen Halbleiterspeicher mit elektrisch mit Tunnelstrom programmier- und löschbaren, nichtflüchtigen Speicherzellen (EEPROM), die in Speicherzellengruppen mit je n Zeilen und in m Spalten geordnet sind, mit in einem Halbleiterkörper gebildeten Speicherzellen mit Source- und Drainzonen und einem dazwischen gebildeten Kanal mit einem darüber liegenden Gateoxid einem sich über das Gateoxid erstreckendes Floating-Gate und einem sich über das Floating-Gate erstreckendes und von ihm durch ein dünnes Dielektrikum getrenntes Controllgate, die einen Floating-Gate-Transistor bilden, wobei das Gateoxid und das dünne Dielektrikum so gewählt sind, daß durch Fowler-Nordheim-Tunnelstrom Elektronen auf das Floating-Gate gelangen, bzw. von ihm abfließen können und bei dem Speicherzellengruppen dadurch gebildet sind, daß die Source und Drain von n Zellen in Serie geschaltet sind und diese serielle Verbindung die Bit-Leitung für die Spalten eines Zellenblocks bildet, daß das Controll-Gate m nebeneinanderliegenden Speicherzellen einer Zeile des Zellenblocks gemeinsam ist und die Wort-Leitung für die Zeile der Speicherzellengruppe bildet.

Die Erfindung betrifft weiter ein Verfahren zum Betrieb eines solchen Halbleiterspeichers.

Ein Halbleiterspeicher dieser Art ist aus IEEE Journ. of Solid-State-Circuits 24 (1989) 5, 1238 bis 1243 bekannt.

Bei diesem bekannten Halbleiterspeicher können sich bei kurzen Zugriffszeiten Probleme durch Überlöschen (over erasing) von Speicherzellen ergeben die üblicherweise durch Einführen eines zusätzlichen Zugriffstransistor gelöst werden. Dies bedeutet aber eine beträchtliche Flächenvergrößerung des Speichers.

Der Erfindung liegt nun die Aufgabe zugrunde, bei einem Halbleiterspeicher der eingangs genannten Art das Problem des Überlöschens auch für kurze Zugriffszeiten ohne nennenswerte Flächenvergrößerung zu lösen.

Diese Aufgabe wird erfindungsgemäß dadurch gelöst, daß sich das Floating-Gate nicht über die gesamte Weite des Kanals erstreckt, so daß in jeder Speicherzelle ein dem Floating-Gate-Transistor parallel geschalteter, nur durch das Controllgate gesteuerter Parallel-Transistor gebildet ist.

Bei einem so aufgebauten Halbleiterspeicher treten - bei nur geringer Erhöhung des Flächenbedarfs - auch bei kurzen Zugriffszeiten keine Überlöschprobleme mehr auf.

Wenn gemäß einer Weiterbildung der Erfindung die unter dem Gateoxid liegenden Gebiete (Injektorgebiete) (50) der n Zellen einer Spalte einer Speicherzellengruppe miteinander verbunden sind und so eine Programmierleitung bilden, die von den Source- und Drainzonen getrennt ist, ergibt sich einmal eine Verringerung der anzulegenden Programmierspannung, da die an jeder Zelle einer Spalte anliegende Programmierspannung von dem Programmierzustand der Zellen einer Spalte unabhängig ist.

Weiter ist es dadurch möglich, die Zellen wahlfrei zu programmieren.

Weitere Ausgestaltungen der Erfindung ergeben sich aus den Unteransprüchen.

Die Erfindung betrifft weiter ein Verfahren zum Betrieb eines Halbleiterspeichers nach dem Hauptanspruch, gemäß dem die angelegten Spannungen so gewählt sind, daß beim Lesen einer Speicherzelle die Parallel-Transistoren der nicht selektierten Speicherzellen leitend sind. So ist sichergestellt, daß unabhängig von dem durch etwaiges Überlöschen bedingten Zustand der Speicherzellen nur die selektierte Zelle gelesen wird. Die Zahl der Speicherzellen eines Zellenblocks ist dabei nur durch die höchstzulässige Zugriffszeit begrenzt.

Ein Ausführungsbeispiel der Erfindung wird im folgenden anhand der beigefügten Zeichnungen näher erläutert.

Es zeigen:

Fig. 1     das Layout einer Speicherzelle eines Halbleiterspeichers nach der Erfindung,

Fig. 2     das Layout einer aus 4 Speicherzellen nach Fig. 1 bestehenden Speicherzellengruppe,

Fig. 3     einen Schnitt durch eine Speicherzelle entlang der Linie III-III in Figur 1,

Fig. 4     einen Schnitt durch eine Speicherzelle entlang der Linie IV-IV in Figur 1 und

Fig. 5     das Schaltbild der aus 4 Speicherzellen bestehenden Speicherzellengruppe nach Fig. 2.

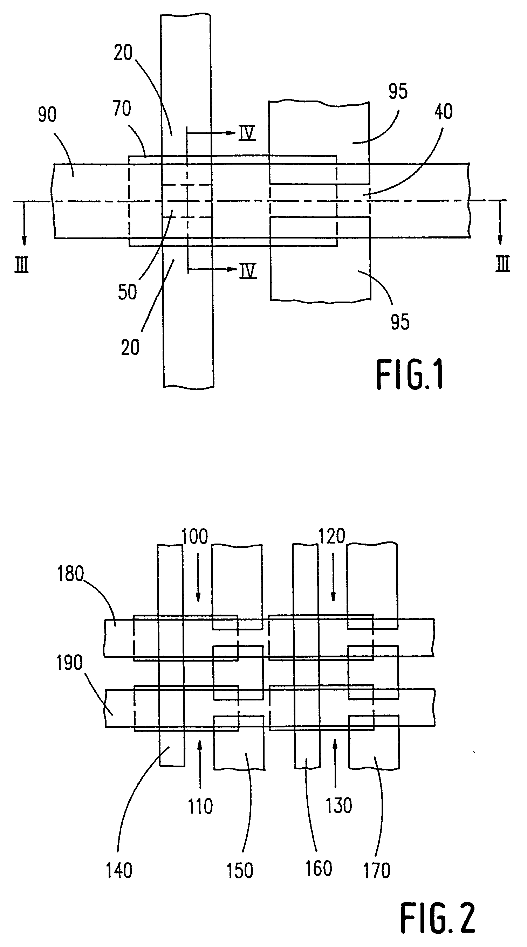

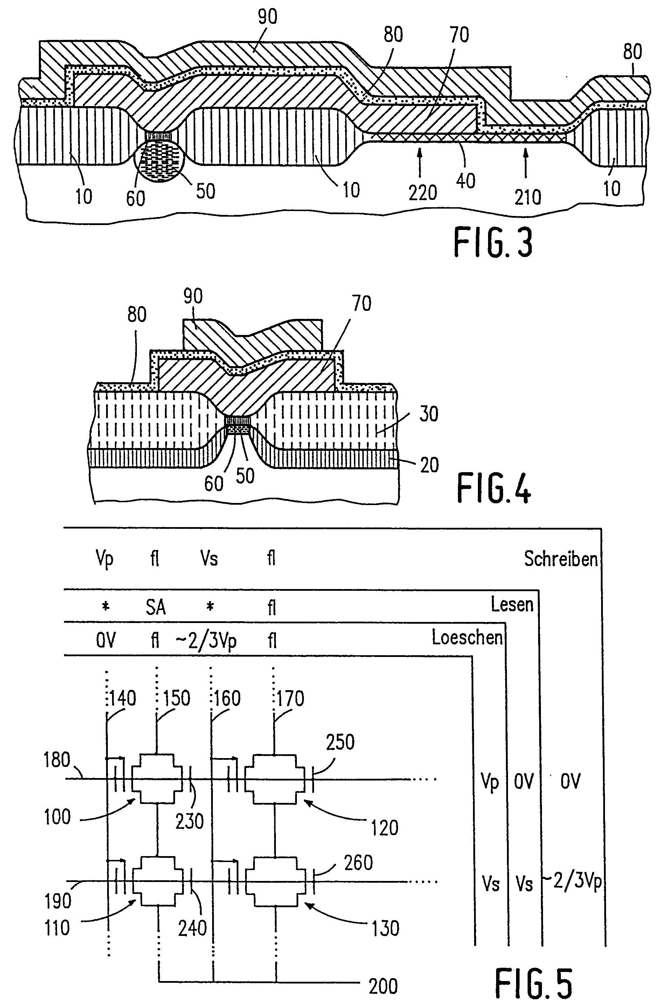

Die Figur 1 zeigt das Layout einer Speicherzelle eines erfindungsgemäßen Halbleiterspeichers. Ein Schnitt durch diese Speicherzelle entlang der Linien III-III und IV-IV ist in den Figuren 3 und 4 dargestellt.

Realisiert sind die Speicherzellen in einem Substrat aus P-leitendem Silicium.

Auf diesen Halbleiterkörper wird zunächst ein etwa 500 nm dickes Oxid 10 aufgewachsen.

Anschließend werden die $N^+$-leitenden Gebiete 20, die später zusammen mit den Injektorgebieten die Programmier-Leitung bilden durch Implantation erzeugt. Dann wird wieder oxidiert, so daß sowohl das zuerst aufgebrachte Oxid 10 als auch das über den Gebieten 20 gebildete Oxid 30 eine Dicke von etwa 800 nm haben.

Im nächsten Schritt wird das Gateoxid 40 mit einer Dicke von 25 nm aufgewachsen. Bei 60 wird dieses Oxid dann abgeätzt, das Injektorgebiet 50 implantiert und dann ein etwa 8 nm dickes Tunneloxid 60 aufgewachsen.

Anschließend wird die das Floating-Gate bildende erste Polysiliciumschicht 70 deponiert, dotiert und strukturiert.

Anschließend wird ein etwa 40 nm dickes Dielektrikum 80 aus Oxinitrid und darauf dann eine zweite, das Controll-Gate bildende, etwa 200 bis 400 nm dicke Polysiliciumschicht 90 aufgebracht und diese dann dotiert und strukturiert.

Der Transistor der so hergestellten Speicherzelle besteht also - wie Fig. 3 zeigt - aus zwei parallel geschalteten Transistoren, wobei der eine Transistor 220 durch den unter dem Floating-Gate 70 liegenden Teil des Kanals und der zweite zusätzliche Transistor 210 durch den nur unter dem Controllgate 90 liegenden Teil des Kanals gebildet wird.

Die Source- und Draingebiete 95 dieser Transistoren werden durch Implantation nach dem Aufbringen der zweiten Polysiliciumschicht 90 selbstjustierend hergestellt. Es ist aber auch möglich sie durch eine vergrabene N + -leitende Schicht zu bilden.

In der Figur 2 ist eine, nur als Beispiel dienende Speicherzellengruppe mit 2x2 Speicherzeilen dargestellt und in der Figur 5 das Schaltbild dieser Gruppe mit den Zellen 100, 110, 120, 130.
Die Bit-Leitung für die Zellen 100 und 110 ist mit 150 bezeichnet, die Bit-Leitung für die Zellen 120 und 130 mit 170. Die an einer Bit-Leitung liegenden Zellen sind in Serie geschaltet, so daß die Source der Zelle 100 gleichzeitig die Drain der Zelle 110 bildet usw. Die Sourcegebiete der letzten Zellen jeder Spalte liegen an einer gemeinsamen Sourceleitung 200. Die Wort-Leitung für die Zellen 100 und 120 ist mit 180 und die Wort-Leitung für die Zellen 110 und 130 mit 190 bezeichnet. An einer Wort-Leitung liegen abhängig von der Speichergröße 8 * x Zellen. Die Programmier-Leitungen 140 und 160 dienen zum Programmieren/Löschen der Zellen 100 und 110 bzw. 120 und 130.

Der Halbleiterspeicher wird nun so betrieben, daß die angelegten Spannungen so gewählt sind, daß beim Lesen die Parallel-Transistoren (240, 260) der nichtselektierten Speicherzellenzeilen einer Speicherzellengruppe leitend sind.
Soll z.B. die Zelle 100 selektiert und gelesen werden, so wird an die Wort-Leitungen (hier 190) der nichtselektierten Zellen die Versorgungsspannung Vs (z.B. 5 V angelegt), so daß unabhängig vom Ladungszustand des Floating-Gate-Transistors der Parallel-Transistor 240, 260 durchgeschaltet ist. An die Wort-Leitung 180 an der die auszulesende Zelle liegt, wird eine Spannung von 0 V angelegt, so daß der Parallel-Transistor 230 sperrt. An die Bit-Leitung 150 ist ein Leseverstärker SA angeschlossen und die gemeinsame Sourceleitung 200 auf Massepotential gelegt. Es hängt jetzt von dem Ladungszustand des Floating-Gates der Speicherzelle 100 ab ob ein Strom fließt (wenn das Gate positiv ist, entspricht einer logischen 1) oder kein Strom fließt (wenn das Gate negativ ist, entspricht einer logischen 0).

Zum Löschen der selektierten Zelle 100 wird an die Wort-Leitung 180 an der diese Zelle liegt, die Programmierspannung Vp (etwa 13 V) angelegt und an die Programmleitung 140 an der diese Zelle liegt, 0 V. Durch die kapazitive Kopplung zwischen der ersten Polysiliciumschicht 70, d.h. dem Floating-Gate und der zweiten Polysiliciumschicht 90, d.h. dem Controllgate, fällt ein Großteil der angelegten Spannung Vp über dem Tunneloxid 60 (siehe Figur 3 und 4) ab, so daß durch ein Fowler-Nordheim-Tunnelstrom Elektronen auf das Floating-Gate 70 gelangen und es negativ aufladen. Damit die nichtselektierten Zellen 110, 120 und 130 nicht mit gelöscht werden, liegen an der Wort-Leitung 190, an der nur nichtselektierte Zellen liegen, die Betriebsspannung Vs und an der nichtselektierten Programmleitung 160 etwa 2/3 Vp.
Um in die selektierte Zelle 100 zu schreiben, wird an die Wort-Leitung 180 an der diese Zelle liegt, 0 V angelegt, an die Programmleitung 140 an der diese Zelle liegt Vp (etwa 13 V). Durch die kapazitive Kopplung zwischen der ersten Polysiliciumschicht 70, dem Floating-Gate, und der zweiten Polysiliciumschicht 90, dem Controll-Gate, fällt wieder ein Großteil der angelegten Spannung Vp über dem Tunneloxid 60 ab, so daß wieder durch einen Fowler-Nordheim-Tunnelstrom Elektronen vom Floating-Gate 70 herunterfließen und es positiv aufladen. Damit die nichtselektierten Zellen 110, 120 und 130 nicht mitprogrammiert werden, liegen an der Wort-Leitung 190 an der nur nichtselektierte Zellen liegen, etwa 2/3 Vp an und an der Programm-Leitung 160 für die nichtselektierten Zellen die Spannung Vs. Die bei den drei Vorgängen: Löschen, Lesen, Schreiben an den Wort- Bit- und Programmierleitungen liegenden Spannungen sind (für den Fall, daß die Zelle 100 selektiert ist) in die Randleisten der Fig. 5 eingetragen. Dabei bedeutet fl daß diese Leitung schwebt (floatet), während * bedeutet, daß die Leitung schwebt oder an ~ 1/2 Vs liegt.

**Patentansprüche**

1. Halbleiterspeicher mit elektrisch mit Tunnelstrom programmier- und löschbaren, nichtflüchtigen Speicherzellen (EEPROM), die in Speicherzellengruppen mit je n Zeilen und in mSpalten geordnet sind, mit in einem Halbleiterkörper gebildeten Speicherzellen mit Source- und Drainzonen und einem dazwischen gebildeten Kanal mit einem darüber liegenden Gateoxid einem sich über das Gateoxid (40) erstreckendes Floating-Gate (70) und einem sich über das Floating-Gate erstreckendes und von ihm durch ein dünnes Dielektrikum getrenntes Controllgate (90), die einen Floating-Gate-Transistor bilden, wobei das Tunneloxid und das dünne Dielektrikum so gewählt sind, daß durch Fowler-Nordheim-Tunnelstrom Elektronen auf das Floating-Gate gelangen, bzw. von ihm abfließen können, und bei dem Speicherzellengruppen dadurch gebildet sind, daß die Source und Drain von n Zellen in Serie geschaltet sind und diese serielle Verbindung die Bit-Leitung (150, 170) für die Spalten eines Zellenblocks bildet, daß das Controllgate (90) m nebeneinanderliegenden Speicherzellen einer Zeile des Zellenblocks gemeinsam ist und die Wort-Leitung (180, 190) für die Zeile der Speicherzellengruppe bildet,
dadurch gekennzeichnet,
daß sich das Floating-Gate nicht über die gesamte Weite des Kanals erstreckt, so daß in jeder Speicherzelle ein dem Floating-Gate-Transistor (220) parallel geschalteter, nur durch das Controllgate (90) gesteuerter Parallel-Transistor (210) gebildet ist.

2.  Halbleiterspeicher nach Anspruch 1,
dadurch gekennzeichnet,
daß die unter dem Gateoxid liegenden Gebiete (Injektorgebiet) (50) der n Zellen einer Spalte einer Speicherzellengruppe miteinander verbunden sind und so eine Programmier-Leitung bilden die von den Source- und Drainzonen getrennt ist.

3.  Halbleiterspeicher nach Anspruch 2,
dadurch gekennzeichnet,
daß die Injektorgebiete (50) der einzelnen Zellen eine Spalte durch hochdotierte Gebiete gleichen Leitungstyps so miteinander verbunden sind, daß eine streifenförmige Programmier-Leitung (140,160) gebildet ist.

4.  Verfahren zum Betrieb eines Halbleiterspeichers nach einem der vorangehenden Ansprüche,
dadurch gekennzeichnet,
daß die angelegten Spannungen so gewählt sind, daß beim Lesen die Parallel-Transistoren (210) der nicht selektierten Speicherzellen leitend sind.

FIG.1

FIG.2

FIG.3

FIG.4

FIG.5